(19) Europäisches Patentamt

European Patent Office

Office européen des brevets

(11) **EP 1 294 108 A1**

(12) **EUROPEAN PATENT APPLICATION**

(43) Date of publication:
**19.03.2003 Bulletin 2003/12**

(51) Int Cl.7: **H04B 7/26**, H03M 13/21

(21) Application number: **01810877.9**

(22) Date of filing: **11.09.2001**

| | |
|---|---|
| (84) Designated Contracting States:<br>**AT BE CH CY DE DK ES FI FR GB GR IE IT LI LU<br>MC NL PT SE TR**<br>Designated Extension States:<br>**AL LT LV MK RO SI**<br><br>(71) Applicant: **Ascom Systec AG**<br>**5506 Mägenwil (CH)** | (72) Inventor: **Maucher, Johannes, Dr. Ing.**<br>**5522 Tägerig (CH)**<br><br>(74) Representative:<br>**Roshardt, Werner Alfred, Dipl.-Phys.**<br>**Keller & Partner**<br>**Patentanwälte AG**<br>**Schmiedenplatz 5**<br>**Postfach**<br>**3000 Bern 7 (CH)** |

(54) **Process for decoding of non-linear codes**

(57)    In a process for decoding of non-linear codes in digital data transmission, fulfilling the condition of rectangularity, the Viterbi algorithm is used in a trellis of the code with a minimal number of edges and vertices, thus decreasing the number of necessary operations. The process may be applied especially to synchronization of telecommunication systems, namely to UMTS cell search. A distance-dependent merging algorithm may efficiently generate a minimal trellis of a given code. A storage means (11) contains the minimal trellis of the code occurring at code group determination and frame synchronization allowing for applying the Viterbi-decoding algorithm using calculation means (10) and (13).

Fig. 1

**EP 1 294 108 A1**

## Description

### Technical Field

The invention relates to a process and a device for decoding a transmission signal that is coded by a non-linear code.

### Prior Art

The decoding of non-linear code as it appears often during synchronization of two stations for digital data transmission is achieved using a Maximum Likelihood (ML) method. Generally, a brute force method is used which compares all the possible codes with the received information. The ML-decoding strategy working with the least number of operations for linear codes, namely the Viterbi algorithm in a minimal trellis of the code, cannot generally be applied to non-linear codes.

An important application of the decoding of non-linear codes is the cell search process of the UMTS telecommunication system. It has already been proposed to reduce the number of necessary operations for this procedure by combining two steps of the process, namely code group identification and frame synchronization (J. Nystrom, K. Jamal, Y.-P. E. Wang and R. Esmailzadeh, "Comparison of cell search methods for asynchronous W-CDMA cellular system", in Proceedings of IEEE 1st International Conference on Universal Personal Communications, Florence, Italy, 1998). A further reduction of time needed can be achieved by implementing the cell search procedure in a pipelined approach (Y.-P. E. Wang and T. Ottoson, "Cell-Search in W-CDMA", IEEE Selected Areas in Communications, Vol. 18, No. 8, August 2000).

### Summary of the invention

The object of the invention is to indicate a process that performs the decoding of non-linear codes, especially at UMTS cell search, with a smaller number of operations and thus using a smaller amount of time compared to the brute force method.

According to the invention, the solution consists in using the Viterbi-decoding algorithm in a trellis with a reduced number of vertices and a reduced number of edges compared to the trivial trellis. (The algorithm applied to the trivial trellis corresponding identically to the brute force method.) Whereas such trellises do not generally exist for non-linear codes, it has been found that they are present for a subclass of non-linear codes called rectangular codes. A rectangular code $B$ of length $n$ over symbol alphabet $Q$ can be defined as follows: For an arbitrary $t \in \{1,...,n$ -1$\}$ let $\underline{p}_j$ be vectors of length $t$ and $\underline{f}_j$ be vectors of length $n$-$t$ with symbols from $Q$. Then $B$ is rectangular if

$$(\underline{p}_1, \underline{f}_1), (\underline{p}_1, \underline{f}_2), (\underline{p}_2, \underline{f}_1) \in B \text{ implies } (\underline{p}_2, \underline{f}_2) \in B.$$

An important advantage of the invention consists in the application of the Viterbi algorithm to a class of non-linear, namely rectangular, codes reduces the number of operations necessary to perform the decoding process and thus reduces the time used. An example of a rectangular code is the code used in the scrambling code group identification and frame synchronization during the UMTS cell search process. Without losing the possibilities of combining these two steps or implementing the whole procedure in a pipelined approach, the invention allows for further reducing the mean acquisition time.

Preferably, the minimal trellis of a rectangular code will be constructed using an extension of the merging algorithm (V. Sidorenko, J. Maucher and M. Bossert, "On the Theory of Rectangular Codes", in Proceedings of 6th international workshop on Algebraic and Combinatorial Coding Theory, Pskov, Russia, June 1998), called distance-dependent merging algorithm, which is explained in the following. The notation that will be used is as follows: A trellis of a length $n$ block code $B$ with code symbols from the alphabet $Q$ consists of a set of vertices $V = V_0 \cup V_1 \cup ... \cup V_n$ and a set of edges $E = E_1 \cup E_2 \cup ... \cup E_n$. The edges are labelled by symbols from $Q$ and each edge $e \in E_t$ in depth $t$ connects a vertex $v \in V_{t-1}$ in depth $t$-1 with a vertex $v' \in V_t$ in depth $t$. There exists only a single vertex $v_r$ (root vertex) at depth $t = 0$ and a single vertex $v_g$ (goal vertex) at depth $t = n$. Each vertex $v \in V_t$ is connected with at least one vertex of $V_{t-1}$ and at least one vertex of $V_{t+1}$. Each set of $n$ connected edges, starting at the root $v_r$ and terminating in the goal $v_g$ is called a path $p$. In a trellis of a block code $B$ for each code word $b \in B$ there exists a unique path $p$ in the trellis. In a trellis two vertices $v_1, v_2 \in V_t$ at depth $t$ are called relatives, if there exists a vertex $v'$ in depth $t$-1 (left relatives) or $t$+1 (right relatives), which is connected to both $v_1$ and $v_2$ via edges $e_1$ and $e_2$ and both edges having the same label. In order to obtain the minimal trellis $T_{min}(B)$ of a rectangular code $B$ with length $n$ and minimum Hamming distance $d$, proceed as follows:

- Start from an arbitrary trellis $T'(B)$ of code $B$ (e. g. the trivial trellis),

- for $t \in [1,...,n\text{-}d]$ merge all left relatives in the trellis and delete unnecessary edges,

- for $t \in [n\text{-}1,...,d]$ merge all right relatives in the trellis and delete unnecessary edges.

After these steps, the new trellis obtained is a minimal trellis of the code $B$.

In general, a permutation $B'$ of a code $B$ can be obtained by a fixed reordering of the coordinates within each code word of $B$. The permutation $B'$ is equivalent to the original code in the sense that the code parameters length $n$, cardinality $|B|$ and minimum Hamming distance $d$ remain constant. From a permuted code one can easily get back the initial code. However, the complexity of the minimal trellis can vary drastically for different code permutations. It may therefore be preferable to use a permutation of the actual code in the decoding procedure. Similarly, defining a code used in digital data transmission one may chose a permutation of the code having a minimal trellis as simple as possible.

The synchronization of different stations in telecommunication systems, such as mobile stations and base stations, often includes the determination of a code, e. g. a scrambling code, which in general is non-linear. In the case where this non-linear code is a rectangular code, the invented process leads to a reduction of the mean acquisition time.

In the currently specified W-CDMA based Universal Mobile Telecommunications System (UMTS) the cell search procedure includes a combined scrambling code group identification and frame synchronization procedure. It corresponds to finding the most likely transmitted code word among a set of 960 code words. These 960 code words constitute a subcode of a Reed Solomon code. The code has length $n$ =15 and minimum Hamming distance $d$ =13. Furthermore, it is non-linear but fulfills the condition for rectangularity stated above. For this case, one may show that the number of operations necessary to perform the scrambling code group identification and frame synchronization procedure is 21% smaller using the Viterbi algorithm on the minimal trellis compared to the brute force method. Using a permutation of the code does not further decrease the number of necessary operations significantly in this case.

An arrangement for performing the process according to the invention may calculate itself the reduced trellis of the rectangular code. The reduced trellis may also be calculated offline and stored in the arrangement. A preferred embodiment is a receiver performing the decoding of the shifted code word received during UMTS cell search, containing information about the scrambling code group as well as about frame synchronisation, using the Viterbi algorithm on a minimal trellis stored in a storage means of the receiver, where the path metrics are obtained from accumulating the correlations between the received signal and the known code sequences.

Other advantageous embodiments and combinations of features come out from the detailed description below and the totality of the claims.

**Brief description of the drawings**

The drawings used to explain the embodiments show:

Fig. 1    A block diagram of a circuit according to the invention with determination of the slot synchronization, frame synchronization and code group identification in UMTS cell search.

Fig. 2    Trivial trellis of an example code $U^*$.

Fig. 3    Corresponding minimal trellis of the example code $U^*$.

In the figures, the same components are given the same reference symbols.

**Preferred Embodiments**

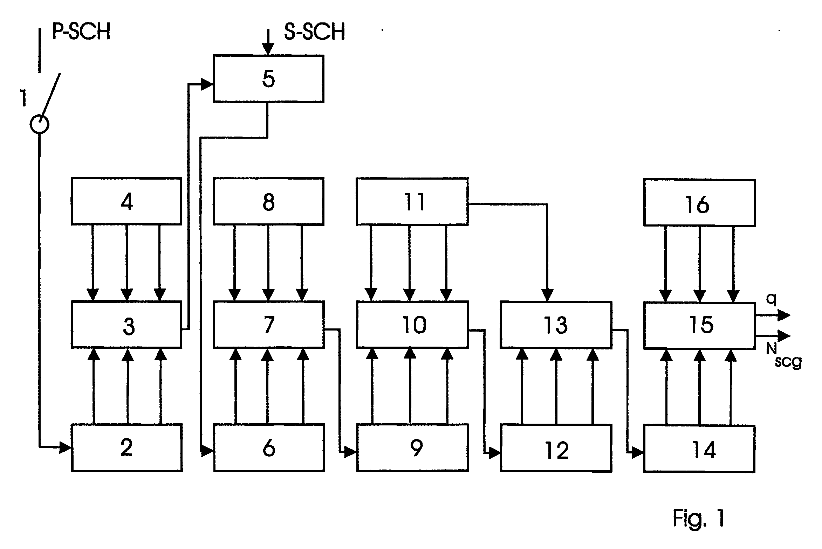

Figure 1 shows as an example a block diagram of a circuit according to the invention, which performs slot synchronization, frame synchronization as well as scrambling code group identification in a UMTS cell search procedure. In this case, two physical channels, Primary Synchronization Channel (P-SCH) and Secondary Synchronization Channel (S-SCH) are used. These channels are transmitted continuously from every base station of the system and they are the only channels transmitted that are not scrambled. The information is partitioned into frames (38400 chips/ frame) which are again subdivided into 15 slots. The two synchronization channels are time aligned, i. e. the slots always start at the same time. We denote the sequence transmitted in the $j$-th slot of the P-SCH by $w_j$ and the sequence transmitted in the $j$-th slot of the S-SCH by $s_j$. In the P-SCH in each slot the same modulated code of length 256 chips is transmitted, denoted by $c^{(0)}$, i. e. $w_j = c^{(0)}$ for $j$ = 1,...,15. In each cell the same code $c^{(0)}$ is transmitted.

The code transmitted in the S-SCH differs from cell to cell. We denote the sequences of 15 successive subsequences transmitted repeatedly in the S-SCH of a given cell by $\mathbf{s}= (s_1, s_2, ..., s_{15})$, where the subsequences $s_j$ are elements from a set of length 256 sequences $C = \{c^{(1)}, c^{(2)}, ..., c^{(16)}\}$. There exist 64 different sequences for s assigned to cells such that they differ for neighboring cells. The 64 possible sequences $\mathbf{s} = (c^{(u_1)}, c^{(u_2)}, ..., c^{(u_{15})})$, $u_i \in \{1, ..., 16\}$ can uniquely be mapped to code words $\mathbf{u} = (u_1, u_2, ..., u_{15})$. The resulting set of code words is denoted by $U$ and has the property that each cyclic shift of a code word is neither another code word of $U$ nor a copy of itself. Each code word $\mathbf{u} \in U$ uniquely defines a scrambling code group.

The code containing $U$ and all shifted versions of the codewords in $U$ contains $64 \times 15 = 960$ codewords and is denoted by $U^*$.

In the first step of the cell search the P-SCH is sampled with a switch 1 during the period corresponding to the length of 1 slot and stored in buffer storage device 2. In order to achieve slot synchronization, portions of the received signal $p_i$ are correlated (calculation circuit 3) with the known signal $c^{(0)}$ stored in storage 4. The peak of the correlation corresponds to the slot start. This information is used in to trigger switch 5 which reads in the S-SCH during the period of 1 frame, starting at one of the 15 slots. This information, denoted by $r_{j,i}$, where $j = \{1, .., 15\}$ denotes the slot and $i = \{1, ..., 256\}$ denotes the symbol, is stored in the storage buffer 6. The correlations $S^{(k)}$ between the received signal and the code sequences $c^{(k)} \in C$ stored in storage 8 are calculated (calculation circuit 7) according to

$$S_j^{(k)} = \left| \sum_{i=1}^{256} r_{j,i} c_i^{(k)} \right|, \quad c^{(k)} \in C, \quad j \in \{1, ..., 15\}.$$

This information is stored in buffer storage device 9. For every vertex of the minimal trellis stored in storage 11, the accumulated metric is calculated (calculation circuit 10) according to

$$D(v) = \max_{p(v)} \left( \sum_{(j,k) \in p} S_j^{(k)} \right),$$

i. e. among the paths ending in a given vertex, only the path with the largest accumulated metric is kept, all the other paths are removed. The edges that are not removed are stored (buffer 12) and by backtracking, starting at the goal vertex $v_g$ the most probable code word $\mathbf{u}'$ is determined (calculation circuit 13) as there is only one path of length $n$ left, leading back to the root vertex $v_r$. The code word $\mathbf{u}' \in U^*$ is stored in buffer 14 and all its 15 cyclic shifts are compared (circuit 15) to the 64 code words $u \in U$ stored in storage 16. The cyclic shift $u''$ coinciding with the element of $U$ uniquely determines the scrambling code group $N_{scg}$ as well as the frame timing offset $q$ being the number of positions the code has been shifted.

The process according to the invention is performed advantageously by a special DSP (digital signal processor).

In order to clarify the construction of the minimal trellis using the distance-dependant merging-algorithm, we use a simplified example code $U^*$ because the code used in the UMTS standard is too complex for a clear visualization. The simplified example code $U^*$ corresponds to frames consisting of only 5 slots and the symbols of the sequences are real, $c^{(i)} \in \{-1, +1\}$ (opposed to complex numbers in the case of the UMTS standard). There exist only two possible S-SCH sequences:

$$s_1 = (c^{(1)}, c^{(2)}, c^{(3)}, c^{(4)}, c^{(2)}),$$

$$s_2 = (c^{(1)}, c^{(1)}, c^{(4)}, c^{(2)}, c^{(3)}).$$

Each of them consists of only 5 successive subsequences $s_{i,j}$ which are elements from a set of 4 length 4 sequences $C = \{\mathbf{c}^{(1)}, \mathbf{c}^{(2)}, \mathbf{c}^{(3)}, \mathbf{c}^{(4)}\}$, with

$$c^{(1)} = (-1, -1, -1, -1),$$

$$c^{(2)} = (-1,-1,+1,+1),$$

$$c^{(3)} = (-1,+1,+1,-1),$$

$$c^{(4)} = (-1,+1,-1,+1).$$

The mapping of the sequences $\mathbf{s}_1$ and $\mathbf{s}_2$ to the indices of the subsequences yields the code U with code words

$$u_1 = (1,2,3,4,2),$$

$$u_2 = (1,1,4,2,3).$$

In the second step of the cell search slot synchronization is already available. However, the receiver does not know the frame timing. Therefore it has to determine the most likely code word not only among the two elements of the code $U$, but also among all of their cyclic shifts. This is the code $U^*$ and consists of

$$u_1 = (1,2,3,4,2), u_3 = (2,1,2,3,4), u_5 = (4,2,1,2,3), u_7 = (3,4,2,1,2), u_9 = (2,3,4,2,1),$$

$$u_2 = (1,1,4,2,3), u_4 = (3,1,1,4,2), u_6 = (2,3,1,1,4), u_8 = (4,2,3,1,1), u_{10} = (1,4,2,3,1).$$

The minimum Hamming distance of $U^*$ is seen to be $d = 3$.

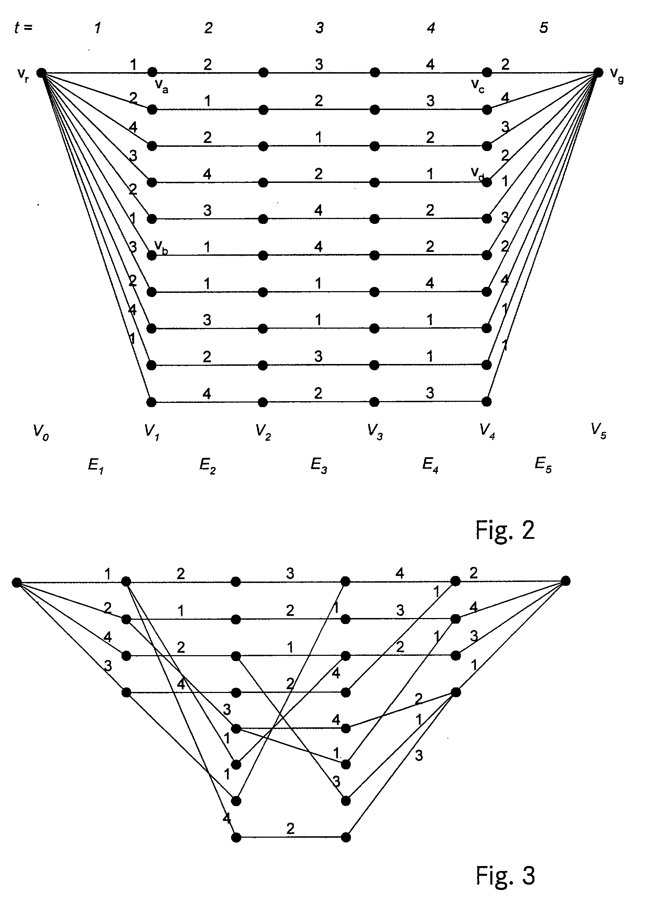

The trivial trellis of these 10 codes is depicted in Figure 2. Trivial means that no paths merge together before they reach the goal vertex $v_g$ at $n = 5$ and no paths ramify from a common vertex except at the root vertex $v_r$ in depth $n = 0$. Using the steps described above, merging left relatives for $t \in [1,2]$ and right relatives for $t \in [4,5]$ as well as deleting unnecessary edges one ends up with the minimal trellis of $U^*$, shown in Figure 3. It is evident that the number of comparisons and the number of additions that have to be performed in the Viterbi-decoding algorithm is decreased.

In summary, it is to be noted that the invention creates a process for decoding non-linear codes, fulfilling the conditions of rectangularity, faster than using brute force methods, independent of the service of the code. The application domain of this process is correspondingly broad.

## Claims

1. Process for decoding a transmission signal that is coded by a non-linear code, **characterized in that** the non-linear code is rectangular and that a Viterbi algorithm is used in a trellis of the code having a reduced number of vertices and a reduced number of edges.

2. Process according to claim 1, **characterized in that** a distance-dependant merging algorithm is used to generate a minimal trellis of the code.

3. Process according to one of claims 1 or 2, **characterized in that** a trellis of a permutation of the code is used.

4. Process according to one of claims 1 to 3, **characterized in that** the decoding is used to synchronize a receiver of a telecommunication system, preferably between mobile stations and base stations.

5. Process according to claim 4, **characterized in that** the decoding is used for scrambling code group identification and for frame synchronization during a UMTS cell search process.

6. Device for decoding a transmission signal that is coded by a non-linear code, **characterized in that** the non-linear code is rectangular and that a Viterbi algorithm is used in a trellis of the code having a reduced number of vertices and a reduced number of edges.

**7.** Device according to claim 5, **characterized in that** means are provided, which use a distance-dependent merging algorithm to generate a minimal trellis of the code.

**8.** Device according to claim 6 or 7, **characterized in that** a trellis of a permutation of the code is used.

**9.** Device according to one of claims 6 to 8, wherein a shifted code word transmitted in a Secondary Synchronization Channel (S-SCH) is determined, out of correlations $S_j^{(k)}$ between a received signal and a plurality of code sequences, comprising:

    a) a storage means (11) for vertices and edges of the minimal trellis,

    b) a buffer storage means (9) for storing the correlations $S_j^{(k)}$,

    c) a calculation means (10) for accumulating the correlations yielding metric values for each vertex in the trellis,

    d) a buffer storage means (12) for storing the accumulated metric values at each vertex as well as remaining paths in the trellis,

    e) a calculation means (13) for finding a path leading to the largest accumulated metric, using a backtracking procedure, corresponding to the code word to be determined.

**10.** Device according to one of claims 6 to 9 **characterized in that** it is constructed to work as a mobile station or as a base station in a mobile communication system.

Fig. 1

Fig. 2

Fig. 3

**European Patent Office**

## EUROPEAN SEARCH REPORT

Application Number

EP 01 81 0877

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | SIDORENKO V ET AL: "Bases of rectangular codes" 2000 IEEE INTERNATIONAL SYMPOSIUM ON INFORMATION THEORY (CAT. NO.00CH37060), 2000 IEEE INTERNATIONAL SYMPOSIUM ON INFORMATION THEORY, SORRENTO, ITALY, 25-30 JUNE 2000, page 30 XP002192703 2000, Piscataway, NJ, USA, IEEE, USA ISBN: 0-7803-5857-0 | 1-3,6-8 | H04B7/26 H03M13/21 |
| Y | * page 30, column 1, line 11 - line 20 * | 4,5,9,10 | |
| X | SIDORENKO V ET AL: "On separability of some known nonlinear block codes" PROCEEDING. 1997 IEEE INTERNATIONAL SYMPOSIUM ON INFORMATION THEORY (CAT. NO.97CH36074), PROCEEDINGS OF IEEE INTERNATIONAL SYMPOSIUM ON INFORMATION THEORY, ULM, GERMANY, 29 JUNE-4 JULY 1997, page 506 XP002192704 1997, New York, NY, USA, IEEE, USA ISBN: 0-7803-3956-8 * abstract * | 1-3,6-8 | |
| D,Y | NYSTROM J ET AL: "Comparison of cell search methods for asynchronous wideband CDMA cellular system" INTERNATIONAL CONFERENCE ON UNIVERSAL PERSONAL COMMUNICATIONS, IEEE, NEW YORK, NY, US, vol. 2, 5 October 1998 (1998-10-05), pages 783-787, XP002138684 * page 783, column 2, line 3 - line 12 * | 4,5,9,10 | TECHNICAL FIELDS SEARCHED (Int.Cl.7) H04B H03M |

The present search report has been drawn up for all claims

| Place of search | Date of completion of the search | Examiner |
|---|---|---|
| THE HAGUE | 12 March 2002 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

  & : member of the same patent family, corresponding document

EPO FORM 1503 03.82 (P04C01)